# EUROPEAN PATENT APPLICATION

(11) **EP 1 498 916 A1**
(43) Date of publication of application: **19.01.2005**
(21) Application number: 04468011.4
(22) Date of filing: 15.07.2004
(51) Int. Cl.: H01F 38/32, H01L 27/22, G01R 21/133

(54) **Integrated circuit provided for a watthour meter**

(30) Priority: 15.07.2003 SI 200300178
(71) Applicant: Iskraemeco, Merjenje in Upravljanje Energije, D.D., 4000 Kranj (SI)
(72) Inventor: Rozman, Miro, 4248 Lesce (SI); Perne, Jozef, 4202 Naklo (SI); Strle, Vojko, 1113 Ljubljana (SI); Bizjak, Uros, 4000 Kranj (SI); Kosmac, Milan, 4274 Zirovnica (SI)
(74) Representative: Gros, Mladen

(57) **Abstract**

An electric current sensor is an integrated coil (2) enclosing a region (3) provided for a processing of analog signals as well a region (4) provided for a processing of digital signals. Two integrated coils (2', 2") may be fabricated spaced from each other on a silicon chip (1), each one of the integrated coils (2', 2") enclosing its respective region (3) and (3') provided for processing analog signals of the corresponding coil, and the region (4) provided for processing digital signals is situated between the two integrated coils (2', 2").

The proposed inductive current sensor does not need any energizing current and the temperature dependence of its signal is smaller as well.

## Description

The invention concerns an integrated circuit provided for a watthour meter and comprising, on a single silicon chip, an electric current sensor and a region provided for processing of analog signals as well as a region provided for processing of digital signals.

There are known numerous watthour meters which are furnished with an integrated electric current sensor and with analog and digital electronic circuits. Hereby sensor signals are processed and the parameters of the electric power delivered to a load *e.g.* the effective current, the energy, the power, the phase angle and other, are calculated.

Interfering influences are eliminated to the highest possible degree by integrating all said meter units on a single silicon chip. In this way an acceptable metering accuracy as well as a high reliability are achieved also at inexpensive models of watthour meters, however, the long-term operation stability is wanted to be improved.

A silicon chip of this kind is described *e.g.* in chapter 2.9.7 in a *Martin Kahmann's* (editor) book entitled *Elektrische Energie, elektronisch gemessen,* 1994, VDE-Verlag GmbH, Berlin and Offenbach. A Hall sensor as *e.g.* integrated when using CMOS technology is applied as an integrated electric current sensor. Hereby the magnetic field, which is the measure of the intensity of the current flowing through the load, is picked up. The Hall sensor is sensitive to temperature variations and to any mechanical load on the silicon chip and consumes electric current for energizing. The temperature dependence may be compensated, but the improvement factor is limited because of allowable limits. The mechanical stress onto the silicon chip, on the one hand increases the offset voltage of the Hall sensor due to the piezoresistance, and, on the other hand, the non-reproducible Hall-sensor temperature dependence results from the piezo-Hall effect. These are the causes a for lower measuring accuracy as well as time stability of the Hall sensor. A special housing or a bonding method may be used to eliminate the mechanical stress, bat the current consumption cannot be avoided.

Consequently, the technical problem to be solved by the present invention is to propose an integrated circuit provided for a watthour meter, which circuit will be furnished with such an electric current sensor that interfering influences will be eliminated to the highest possible degree.

According to the invention said technical problem is solved by an integrated circuit of said kind, the feature of the invention of which integrated circuit is comprised in the characterizing part of the first claim. Features of further embodiments of the invention are specified in dependent claims.

The invention will now be explained in more detail by way of the description of embodiments and with reference to the accompanying drawing representing in
- Fig. 1: the basic embodiment of the integrated circuit of the invention provided for a watthour meter and
- Fig. 2: a further embodiment of the integrated circuit of the invention.

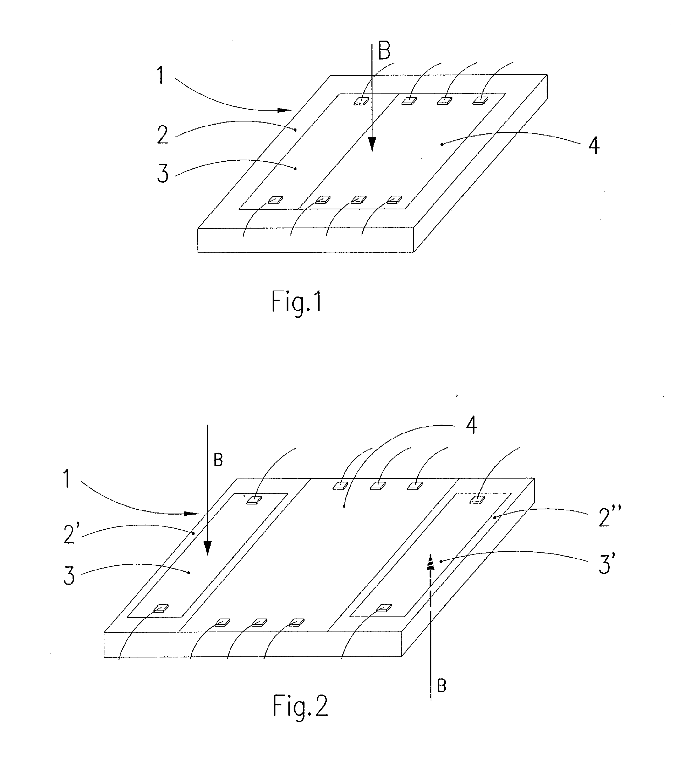

An integrated circuit provided for a watthour meter is fabricated on a single silicon chip 1 and comprises an electric current sensor, which according to the invention is a single integrated coil 2 or two differentially situated integrated coils 2', 2", a region 3 provided for processing analog signals and a region 4 provided for processing digital signals (Fig. 1 and 2).

In the basic embodiment the integrated coil 2 encloses the region 3 provided with a circuit for processing analog signals and the region 4 provided for processing digital signals (Fig. 1).

In another embodiment of the integrated circuit according to the invention two integrated coils 2', 2" are fabricated on the silicon chip 1 spaced from each other. The two integrated coils 2', 2" are connected differentially (Fig. 2). Advantageously, each of the two integrated coils 2', 2" encloses its respective region 3 and 3' provided for processing the analog measuring signal from the corresponding coil, the region 4 provided for processing the digital signal, however, is situated between both integrated coils 2', 2".

In the basic embodiment lines B of force of the magnetic field within the integrated coil 2, which magnetic field is a measure for the electric current through the load, stick through the silicon chip 1 at a right angle. In the further embodiment, however, lines B of force of the magnetic field within the first integrated coil 2' stick through the silicon chip 1 at a right angle from one side and within the second integrated coil 2" from the other side, the magnetic field densities of both magnetic fields being advantageously equal. The influence of any external interfering magnetic field is eliminated by means of such differential embodiment.

The integrated coil 2 or coils 2', 2" are fabricated on the silicon chip according to one of the standard methods in the CMOS or BiCMOS technology and the expenses are lower than the manufacturing expenses of Hall sensors. The assembling may also be performed according to one of the known methods.

The integrated circuit of the invention is fabricated in a such way that the proposed chip according to any of the disclosed embodiments can be inserted into a known watthour meter depending on the embodiment of magnetic system in the wathour meter.

The voltage induced in the integrated coil 2 or coils 2', 2" is then advantageously processed by a method as disclosed in the patent application SI 200200166 (EP 1 378 756 A2) by the present applicant.

The proposed inductive current sensor needs no energizing current and the temperature dependence of its signal is smaller as well. The technical features and the measuring accuracy of the watthour meter fabricated in this way are improved.

## Claims

1. Integrated circuit, provided for a watthour meter and comprising, on a single silicon chip (1), an electric current sensor and a region (3) provided for processing analog signals as well as a region (4) provided for processing digital signals,
**characterized in**
**that** the electric current sensor is an integrated coil (2; 2', 2").

2. Integrated circuit as recited in claim 1, **characterized in**
**that** the integrated coil (2) encloses the region (3) provided for processing analog signals as well as the region (4) provided for processing digital signals.

3. Integrated circuit as recited in claim 1 or 2, **characterized in**
**that** two integrated coils (2', 2") are fabricated spaced one from another on the silicon chip (1).

4. Integrated circuit as recited in claim 3, **characterized in**
**that** each one of two integrated coils (2', 2") encloses its respective region (3) and (3') provided for processing the analog coil signals and the region (4) provided for a processing digital signals is situated between the two integrated coils (2', 2").
